# EUROPEAN PATENT SPECIFICATION

(11) **EP 1 545 178 B1**
(45) Date of publication and mention of the grant of the patent: **14.02.2007**
(21) Application number: 03028689.2
(22) Date of filing: 16.12.2003
(51) Int. Cl.: H05K 5/02

(54) **Computer housing containing a lift-type positioning structure for a bracket of a computer interface card**
Computergehäuse mit einer aufklappbaren Rahmenstruktur für eine Computerkarte
Boîtier d'ordinateur contenant une structure articulée pour un cadre qui reçoit une carte d'interface d'ordinateur

(43) Date of publication of application: 22.06.2005
(73) Proprietor: Shuttle Inc., Nei-Hu Dist., Taipei (TW)
(72) Inventor: Yu, Tony, Taipei (TW)
(74) Representative: Urner, Peter

(56) References cited:
- EP-A- 1 282 346
- DE-U- 1 881 174
- US-A- 6 038 125

## Description

### BACKROUND OF THE INVENTION

The present invention relates to a computer housing containing a lift-type positioning structure for a lift-type bracket of a computer interface card, and more particular, a lift-type lid suitable for use in a protruding positioning structure for a bracket of a computer interface card, so as to cover through holes of the computer housing.

The interface card is basically constructed by a circuit board that has a gold finger and a inverse L-shape bracket. The bracket is locked with a window frame structure, which is typically referred as "rear window", by screws. The window frame has at least one or a plurality of slots for accommodating a vertical body of the bracket with connectors formed thereon. To comply with the horizontal body of the bracket, the window frame has a horizontal platform for locking the bracket. Therefore, the rear of the housing includes recessed an protruding designs. The former includes a recessed window frame, and the recessed portion constructs the horizontal platform. The latter includes the window frame onto a rear plate of the housing and a horizontal platform extending from the rear plate of the housing. The recessed window frame provides better allness. However, the housing has a larger depth to waste a lot of space. Therefore, the recessed type is more applicable to large housings. The protruding type requires smaller depth and is more applicable to smaller housings.

The computer housing includes the protruding window frame needs to open a through hole on the slot for the horizontal portion of the bracket to extend outside of the housing. Thereby, the bracket can be secured to the window frame. However, to prevent leakage of electromagnetic wave, the through hole has to be covered by a shield. The conventional shield includes a shed place across the through hole and two screws fastening the shed to a back plate of the computer housing. The shed extends outwardly and downwardly to cover both the through hole and the platform of the window frame. This type of shield requires threading and unthreading the screws every time when the interface card is installed in or removed from the computer. It is very inconvenient for assembling and disassembling the interface card, particularly for those who install and remove interface cards into and from a computer frequently. Many of the users will just remove the shields to result in leakage electromagnetic wave. To resolve this problem, the inventor proposed an L-shape lid to cover the through hole. The lid is placed over the through hole. By lifting up the lid, the through hole is exposed and unblocked. While the lid is released, the vertical plate of the L-shape lid completely covers the through hole, and the horizontal plate thereof is stacked on the horizontal plate of the bracket and the frame. However, such type of lid still requires fasteners such as screws to be secured to the housing, and the user has to continuously lift the lid allowing the through hole to be exposed.

US-A-6,038,125 discloses a computer housing containing a lift-type positioning structure for a lid of a bracket of a computer interface card wherein a protection member is disposed on a side of the receiving slot wherein the protection member is pivotably mounted to the computer housing. The L-shaped protection member is allowed to move between a first position in which it opens the receiving slot and closes a separate power inlet port and a second position in which is blocks the receiving slot and opens the power inlet port. In the first position one arm of the L-shaped protection member protrudes rectangularly from the computer housing and in the second position the same arm partially covers the receiving slot and secures the lid of the receiving slot in its open position. This known embodiment, however, secures the lid in the open position only in a state where the receiving slot is blocked so that the lid has to be manually held in its open position when an interface card shall be inserted into or removed from the receiving slot.

### BRIEF SUMMARY OF THE INVENTION

It is an object of the present invention to define a computer housing containing a lift-type positioning structure according to the preamble of claim 1 wherein the lid for covering the receiving slot of the computer housing can be positioned at a close or open position without additional fasteners and wherein the bracket of the interface card is reliably positioned.
This object is achieved by the computer housing containing a lift-type positioning structure with the features of claim 1.

These and other objectives of the present invention will become obvious to those of ordinary skill in the art after reading the following detailed description of preferred embodiments.

It is to be understood that both the foregoing general description and the following detailed description are exemplary, and are intended to provide further explanation of the invention as claimed.

### BRIEF DESCRIPTION OF THE DRAWINGS

These, as well as other features of the present invention, will become apparent upon reference to the drawings wherein:
Figures 1 shows an exploded view of a first embodiment of the present invention;

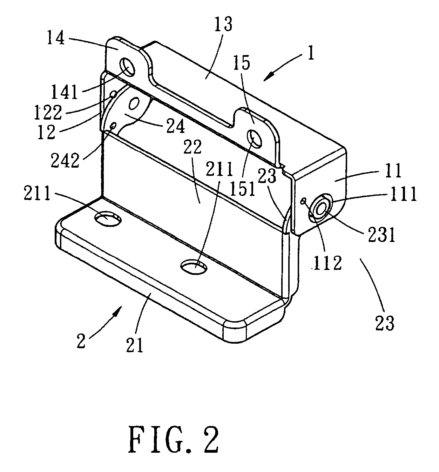

Figure 2 shows a perspective view of the first embodiment;
Figure 3 shows the operation of the first embodiment;
Figure 4 shows a side view of the first embodiment;
Figure 5 shows another side view of the first embodiment;
Figure 6 shows an exploded view of a second embodiment of the present invention;
Figure 7 shows a perspective view of the second embodiment; and
Figure 8 shows the operation of the second embodiment.

### DETAILED DESCRIPTION OF THE INVENTION

Reference will now be made in detail to the preferred embodiments of the present invention, examples of which are illustrated in the accompanying drawings. Wherever possible, the same reference numbers are used in the drawings and the description to refer to the same or like parts.

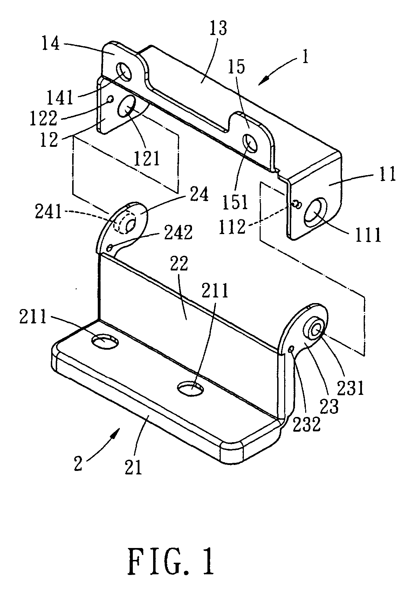

As shown in Figure 1, the first embodiment of the present invention includes a seat member 1 and a lid 2. The seat member 1 is to be mounted to a backplane of a computer housing at a through hole penetrating through the backplane. The seat member 1 includes an elongate horizontal plate 13 and two vertical end plates 11, 12 extending perpendicularly from two opposing ends of the elongate plate. The side plates 11 and 12 are perforated with axial apertures 111 and 121 aligned with each other. The end plates 11 and 12 further comprise protruding spots 112 and 122 extending from inner surfaces thereof towards each other. The protruding spots 112 and 122 are located offside of the axial apertures 111 and 121, respectively. The seat member 1 further comprises a vertical side board extending upwardly from an elongate edge of the horizontal plate 13. The vertical side board includes two positioning boards 14 and 15 perforated with holes 141 and 151, respectively. The lid 2 includes an L-shape body constructed by an elongate horizontal plate 21 and an elongate vertical plate 22. The horizontal plate 21 is perforated with two holes 211 allowing interface cards to be secured thereto. The amount of the holes 211 is determined by the number of interface cards to be installed in the computer, and the distance between the spaces is determined according to the required distance between neighboring interface cards. The positioning structure further comprises two connection plates 23 and 24 extending perpendicularly from two top corners of the vertical plate 22 along a vertical direction. The connection plates 23 and 24 include a pair of cams 231 and 241 for pivotally connecting the axial holes 111 and 121 of the seat member 1. The connection plates 23 and 24 may be perforated with holes 232 and 242 allowing the protruding spots 112 and 122 of the end boards 11 and 12 to be inserted therein. Thereby, when the lid 2 is lifted up to a height at which the protruding spots 112 and 122 are aligned with the holes 232 and 242, the insertion of the protruding spots 112 and 122 into the holes 232 and 242 maintains the lifted position of the lid 2. The lid 2 can be easily released by pushing the horizontal plate 21 downwardly.

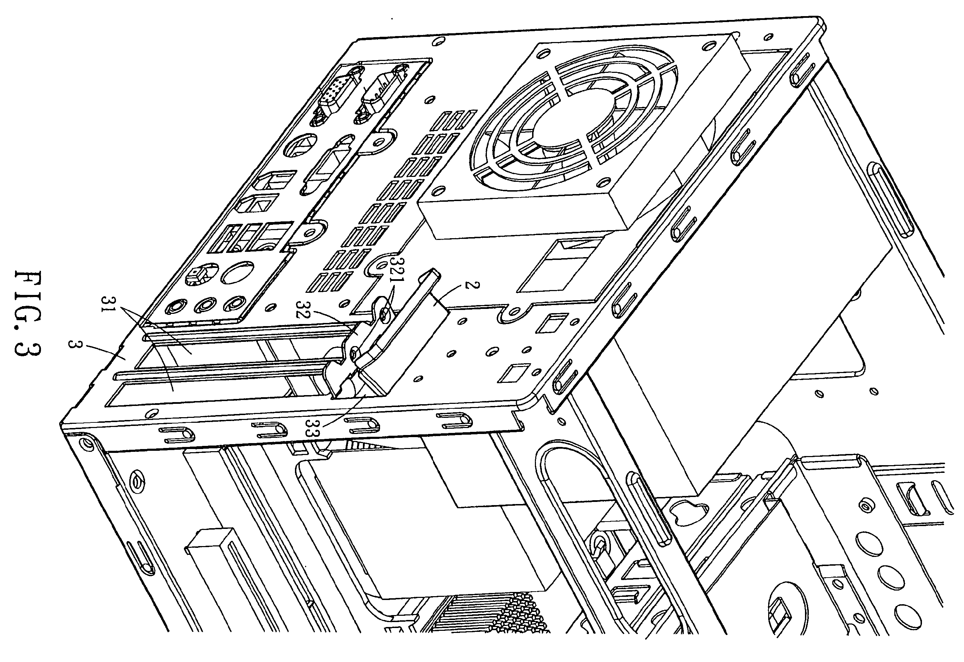

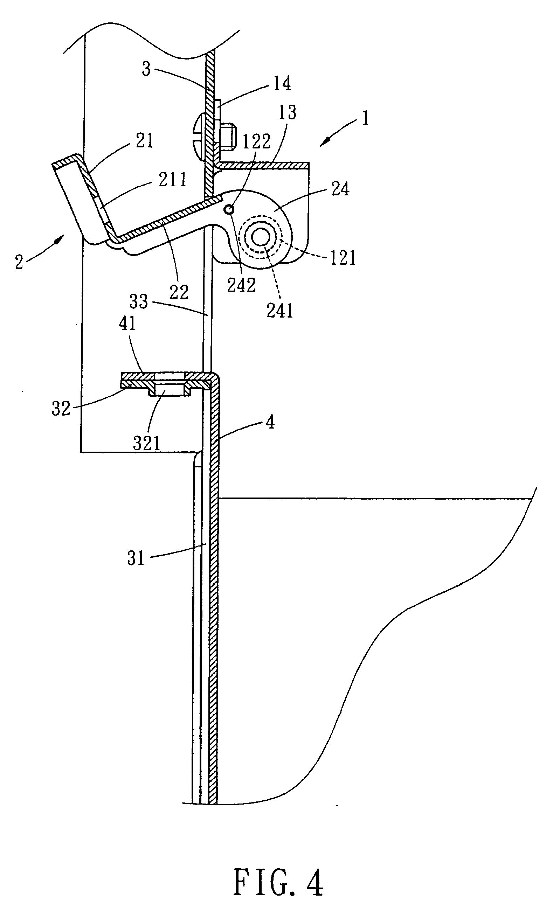

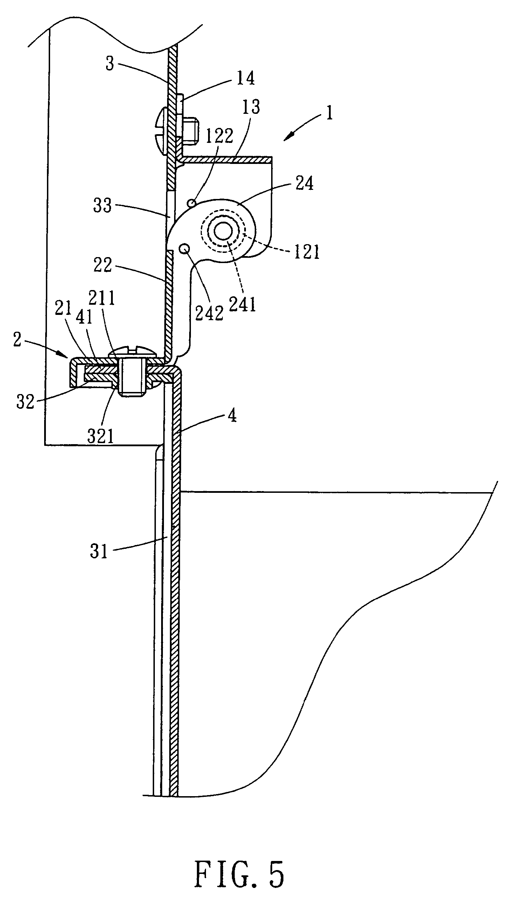

As shown in Figure 3, the position structure as described above is applied to a backplane 3 of a computer casing. The backplane 3 includes two elongate open vertical slots 31 parallel to each other, brackets 4 (as shown in Figures 4 and 5) for receiving interface cards. The backplane 3 is perforated with rectangular slot 33 over the vertical slots 31, and extending from the lower edges of the slot 33 is a horizontal platform 32. Thereby, a protruding positioning structure for an interface card is formed, and the horizontal part 41 of the bracket 4 can extend outside of the housing through the horizontal slot 33 to be stacked over the horizontal platform 32. The horizontal platform 32 is opened with two threaded holes 321 allowing built-in screws of the interface cards to be engaged therewith. The seat member 1 is mounted to the backplane 3 at the edge of the slots 33 using screws or rivets threaded with the positioning holes 141 and 151. Figure 4 shows the status when the lid 2 is lifted up to a fixed position. As shown, the protruding spots 112 and 122 of the seat member 1 are embedded into the holes 232 and 242. Without any external force, the lid 2 is maintained at the open position. Thereby, the slot 33 is exposed, and the bracket 4 can easily pass through the slot 33. When the interface card is installed, by gently pressing the lid 2 downwardly, the slot 33 is covered by the vertical plate 22 of the lid 2, while the horizontal plate 21 is overlying on the horizontal portion 41 of the bracket 4. In addition, the protruding spots 112 and 122 also have the functions of blocking the edges of the connection boards 23 and 24. Therefore, another positioning function is further provided by the protruding spots 112 and 122.

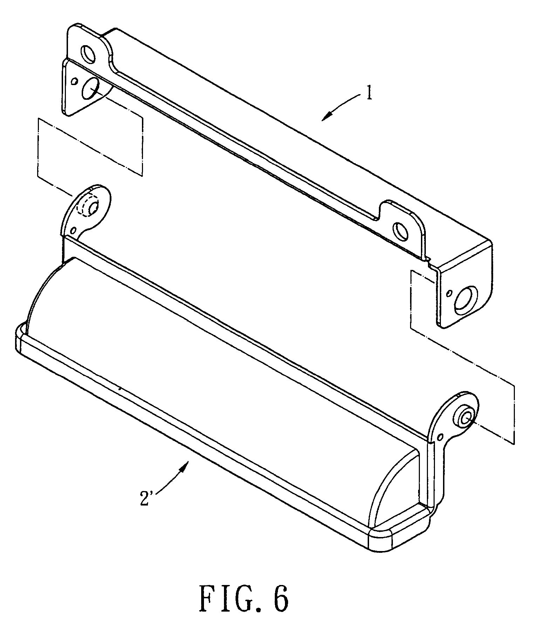

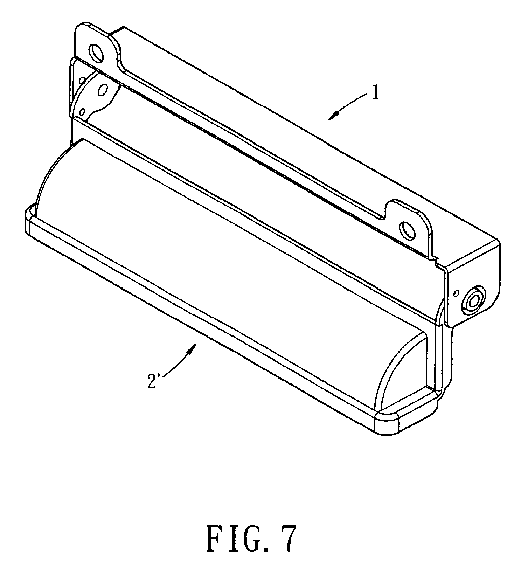

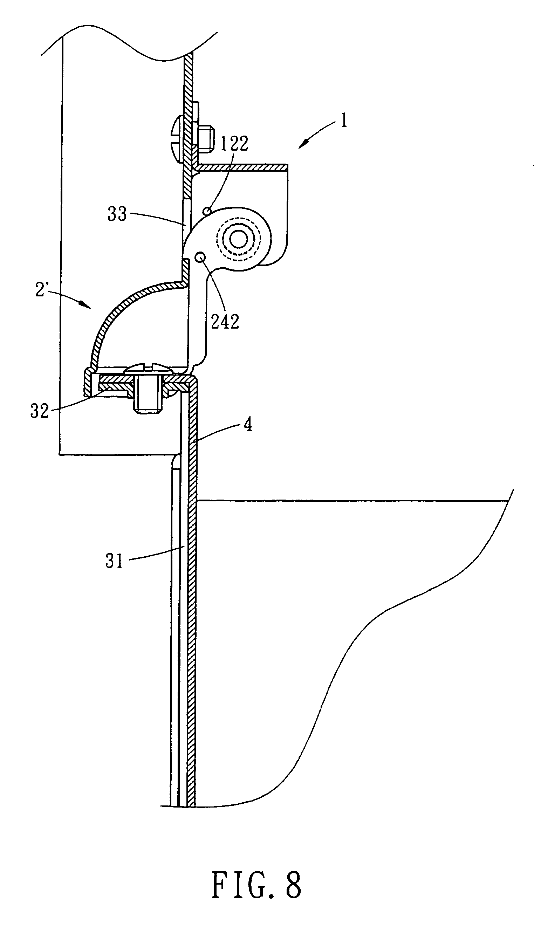

Figures 6-8 show a second embodiment of the present invention. As shown, the lid 2' is in the form of a shed, while the remaining parts of the positioning structure is the same as those in the first embodiment. Therefore, during a closing status as shown in Figure 8, the slot is not directly covered thereby. Instead, the shed covers the horizontal platform 32 to cover the slot. In this embodiment, the lid 2' can be flipped up and down and positioned at the up and down position without using external fasteners.

This disclosure provides exemplary embodiments of the present invention. The scope of this disclosure is not limited by these exemplary embodiments. Numerous variations, whether explicitly provided for by the specification or implied by the specification, such as variations in shape, structure, dimension, type of material or manufacturing process may be implemented by one of skill in the art in view of this disclosure.

## Claims

1. A computer housing containing a lift-type positioning structure for a lid (2) of a bracket (4) of a computer interface card, said computer housing including a receiving slot (31) for receiving the interface card and a rectangular slot (33) over the receiving slot (31), said positioning structure comprising:
- a seat member (1), mounted to the housing at an edge of the rectangular slot (33);
- a lid (2), pivotally connected to the seat member (1) to be lifted up or down; and
- a positioning device (112, 122, 232, 242) for the lid (2) ;
**characterized by**
- a horizontal platform (32) extending perpendicularly from a lower edge of the rectangular slot (33) thus forming a protruding positioning structure for the interface card,
- wherein the positioning device (112, 122, 232, 242) is operative to secure the lid at an open position in which the receiving slot (31) is exposed and the bracket (4) can easily pass through the receiving slot (31).

2. The computer housing of claim 1,
wherein the seat member (1) includes an elongate horizontal plate (13) and two end plates (11, 12) extend perpendicularly and downwardly from two opposing ends of the horizontal plate (13).

3. The computer housing of claim 2,
wherein each of the end plates (11, 12) has an axial hole (111, 121) allowing the lid (2) to be pivotally connected thereto.

4. The computer housing of claim 3,
wherein the seat member (1) comprises two positioning boards (14, 15) extending upwardly from an elongate edge of the horizontal plate (13), and each of the positioning boards (14, 15) is perforated with a positioning hole (141, 151).

5. The computer housing of claim 1,
wherein the lid (2) includes an L-shape body constructed by a horizontal plate (21) and a vertical plate (22), the vertical plate (22) further comprises two connection boards (23, 24) extending away from the two top corners of the vertical plate (22), and each of the connection boards (23, 24) has a cam (231, 241) to be engaged with the seat member (1).

6. The computer housing of claim 5,
wherein the horizontal plate (21) of the lid (2) is perforated with one or more than one holes (211) allowing a screw built in an interface to be threaded therein.

7. The computer housing of claim 1,
wherein the seat member (1) includes two protruding spots (112, 122) at two opposing ends thereof, and the lid (2) includes two holes (232, 242) at two opposing ends thereof to be engaged with the protruding spots (112, 122), so as to position the lid (2) at an open position.

8. The computer housing of claim 7,
wherein the seat member (1) includes two holes at two opposing ends thereof, and the lid (2) includes two protruding spots at two opposing ends thereof to be engaged with the protruding spots, so as to position the lid (2) at an open position.

9. The computer housing of claim 1,
wherein the lid (2') includes a shed with two vertical connection boards extending from two opposing ends thereof, and each of the connection boards includes a cam to be pivotally connected to the seat member (1).

## Patentansprüche

1. Ein Computergehäuse, umfassend eine Deckel (2) anhebbare Positionierungsstruktur für ein Slotblech (4) einer Computer-Interfacekarte, besagtes Computergehäuse umfasst einen Aufnahmeslot (31), um eine Interfacekarte aufzunehmen, und einen rechtwinkligen Slot (33) oberhalb des Aufnahmeslots (31), die besagte Positionierungsstruktur umfasst:
ein Sattelelement (1), das an das Gehäuse an einer Kante des rechtwinkligen Slots (33) befestigt ist;
einen Deckel (2), der drehbar mit dem Sattelelement (1) verbunden ist, um nach oben und nach unten gehoben werden zu können; und
ein Positionierungsgerät (112, 122, 232, 242) für den Deckel (2)
**gekennzeichnet durch**
eine horizontale Plattform (32), die sich senkrecht von einer unteren Kante des rechtwinkligen Slots (33) erstreckt und somit eine hervorstehende Positionierungsstruktur für die Interfacekarte bildet,
wobei das Positionierungsgerät (112, 122, 232, 242) betreibar ist, um den Deckel in einer offenen Position zu sichern, in der der Aufnahmeslot (31) freigelegt ist und die Slotbleche (4) einfach in den Aufnahmeslot (31) führbar sind.

2. Das Computergehäuse nach Anspruch 1,
wobei das Sattelelement (1) eine sich horizontal erstreckende Platte (13) umfasst und zwei Endplatten (11, 12), die sich senkrecht und nach unten von den zwei gegenüber liegenden Enden der horizontalen Platte (13) erstrecken.

3. Das Computergehäuse nach Anspruch 2,
wobei jede der Endplatten (11, 12) axiale Bohrungen (111, 121) aufweist, die es erlauben, dass der Deckel (2) drehbar daran befestigbar ist.

4. Das Computergehäuse nach Anspruch 3, wobei das Sattelelement (1) zwei Haltebaords (14, 15) aufweist, die sich nach oben von einer länglichen Kante der horizontalen Platte (13) erstrecken, und jedes der Halteboards (14, 15) ist mit Haltebohrungen (141, 151) perforiert.

5. Das Computergehäuse nach Anspruch 1, wobei der Deckel (2) einen L-förmigen Körper umfasst, der durch eine horizontale Platte (21) und eine vertikale Platte (22) konstruiert ist, die vertikale Platte (22) umfasst weiterhin zwei Verbindungsboards (23, 24), die sich von den beiden oberen Ecken der vertikalen Platte (22) weg erstrecken und jedes der Verbindungsboards (23, 24) weist eine Nocke (231, 241) auf, die mit den Sattelelementen (1) in Verbindung bringbar ist.

6. Das Computergehäuse nach Anspruch 5, wobei die horizontale Platte (21) des Deckels (2) mit einer oder mehreren Bohrungen (211) perforiert ist, um eine Schraube, die in das Interface eingebaut ist, hinein zu drehen.

7. Das Computergehäuse nach Anspruch 1, wobei das Sattelelement (1) zwei hervorstehende Punkte (112, 122) an dessen beiden Enden aufweist und der Deckel (2) umfasst zwei Bohrungen (232, 242) an zwei gegenüber liegenden Seiten, die mit den hervorstehenden Punkten (112, 122) in Verbindung bringbar sind, so dass der Deckel (2) in eine offenen Position positionierbar ist.

8. Das Computergehäuse nach Anspruch 7, wobei das Sattelelement (1) zwei Bohrungen an zwei einander gegenüber liegenden Enden aufweist und der Deckel (2) umfasst zwei hervorstehende Punkte an zwei einander gegenüber liegenden Seiten, die mit den vorstehenden Punkten in Verbindung bringbar sind, so dass der Deckel (2) in einer offenen Position positionierbar ist.

9. Das Computergehäuse nach Anspruch 1, wobei der Deckel (2') ein Fach mit zwei vertikalen Verbindungsboards umfasst, die sich von zwei gegenüber liegenden Seiten davon erstrecken und jedes der Verbindungsboards umfasst eine Nocke, die drehbar mit dem Sattelelement (1) in Verbindung bringbar ist.

## Revendications

1. Boîtier d'ordinateur contenant une structure de positionnement de type à soulever pour un couvercle (2) d'un cadre (4) d'une carte d'interface d'ordinateur, ledit boîtier d'ordinateur comprenant une fente de réception (31) pour recevoir la carte d'interface et une fente rectangulaire (33) sur la fente de réception (31), ladite structure de positionnement comprenant :
- un élément de siège (1), monté sur le boîtier au niveau d'un bord de la fente rectangulaire (33) ;
- un couvercle (2), relié de manière articulée à l'élément de siège (1) pour être soulevé et abaissé ; et
- un dispositif de positionnement (112, 122, 232, 242) pour le couvercle (2) ;
**caractérisé par**
- une plate-forme horizontale (32) s'étendant perpendiculairement à partir d'un bord inférieur de la fente rectangulaire (33) en formant ainsi une structure de positionnement en saillie pour la carte d'interface,
- dans lequel le dispositif de positionnement (112, 122, 232, 242) est adapté pour bloquer le couvercle dans une position ouverte dans laquelle la fente de réception (31) est exposée et le cadre (4) peut facilement passer à travers la fente de réception (31).

2. Boîtier d'ordinateur selon la revendication 1,
dans lequel l'élément de siège (1) comprend une plaque horizontale allongée (13) et deux plaques latérales (11, 12) s'étendent perpendiculairement et vers le bas à partir de deux extrémités opposées de la plaque horizontale (13).

3. Boîtier d'ordinateur selon la revendication 2,
dans lequel chacune des plaques d'extrémité (11, 12) a un trou axial (111, 121) permettant au couvercle (2) d'être relié de manière articulée à celles-ci.

4. Boîtier d'ordinateur selon la revendication 3,
dans lequel l'élément de siège (1) comprend deux plaques de positionnement (14, 15) s'étendant vers le haut à partir d'un bord allongé de la plaque horizontale (13) et chacune des plaques de positionnement (14, 15) est perforée avec un trou de positionnement (141, 151).

5. Boîtier d'ordinateur selon la revendication 1,
dans lequel le couvercle (2) comprend un corps en forme de L constitué par une plaque horizontale (21) et une plaque verticale (22), la plaque verticale (22) comprend en outre deux plaques de connexion (23, 24) s'étendant en s'éloignant à partir des deux coins de la plaque verticale (22) et chacune des plaques de connexion (23, 24) a une came (231, 241) destinée à être engagée avec l'élément de siège (1).

6. Boîtier d'ordinateur selon la revendication 5,
dans lequel la plaque horizontale (21) du couvercle (2) est perforée avec un ou plusieurs trous (211) permettant de visser à l'intérieur une vis incorporée dans une interface.

7. Boîtier d'ordinateur selon la revendication 1,
dans lequel l'élément de siège (1) comprend deux points en saillie (112, 122) à deux extrémités opposées de celui-ci et le couvercle (2) comprend deux trous (232, 242) à deux extrémités opposées de celui-ci destinés à être engagés avec les points en saillie (112, 122), de manière à positionner le couvercle (2) dans une position ouverte.

8. Boîtier d'ordinateur selon la revendication 7,
dans lequel l'élément de siège (1) comprend deux trous à deux extrémités opposées de celui-ci et le couvercle (2) comprend deux points en saillie à deux extrémités opposées de celui-ci destinés à être engagés avec les points en saillie, de manière à positionner le couvercle (2) dans une position ouverte.

9. Boîtier d'ordinateur selon la revendication 1,
dans lequel le couvercle (2') comprend un auvent avec deux plaques de connexion verticales s'étendant à partir de deux extrémités opposées de celui-ci et chacune des plaques de connexion comprend une came destinée à être reliée de manière pivotante à l'élément de siège (1).
